# FASCICULE DE BREVET EUROPEEN

(11) **EP 0 693 138 B1**
(45) Date de publication et mention de la délivrance du brevet: **13.08.1997**
(21) Numéro de dépôt: 95908237.1
(22) Date de dépôt: 31.01.1995
(51) Int. Cl.: C23C 18/22

(54) **PROCEDE DE METALLISATION DE MATIERES PLASTIQUES, ET PRODUITS AINSI OBTENUS**
VERFAHREN ZUR METALLISIERUNG VON KUNSTSTOFFEN UND AUF DIESE WEISE HERGESTELLTE PRODUKTE
METHOD FOR METALLISING PLASTICS, AND RESULTING PRODUCTS

(30) Priorité: 31.01.1994 BE 9400105
(43) Date de publication de la demande: 24.01.1996
(73) Titulaire: Laude, Lucien Diégo, F-59330 Hautmont (FR)
(72) Inventeur: Laude, Lucien Diégo, F-59330 Hautmont (FR)
(74) Mandataire: Schmitz, Yvon
(86) Numéro de dépôt international: EP9500346
(87) Numéro de publication internationale: WO9520689

(56) Documents cités:
- EP-A- 0 182 379
- EP-A- 0 229 344
- EP-A- 0 272 420

## Description

La présente invention est relative à un procédé de métallisation en trois étapes qui permet de produire une couche métallique adhérente sur la surface d'une pièce en matière plastique, préalablement préparée.

Les matières plastiques peuvent, sous des formes diverses, assurer des fonctions variées dans tous les domaines industriels. Leur structure moléculaire amorphe leur confère un pouvoir d'isolation électrique très important qui les prédispose à une utilisation intensive en particulier dans le secteur électrique, comme support de systèmes actifs ou comme matériau isolant de boîtiers électriques par exemple. Un autre avantage de ces matériaux réside dans leur très grande facilité de mise en oeuvre par moulage ou calandrage. Le désavantage le plus important des plastiques concerne leur fragilité morphologique qui se manifeste en particulier par une température de fusion relativement très basse (220°C, typiquement) qui limite leur utilisation et les rend largement incompatibles avec d'autres matériaux d'usage courant (métaux et céramiques). Un effort de développement permanent est donc nécessaire pour améliorer cette compatibilité. Cet effort a conduit en particulier au développement de thermoplastiques capables de soutenir des températures de l'ordre de 300°C et plus. D'autres plastiques possédant une très bonne tenue mécanique (dureté, rupture à la flexion) ont pu aussi être fabriqués.

Ces caractéristiques intrinsèques dépendent des divers composants (minéraux et/ou organiques) qui sont ajoutés à la matière de base constituée, par exemple, de polycarbonate, polyamide ou autres polymères industriels. Cependant, une difficulté majeure perdure dans ce processus de développement qui concerne la métallisation, ou interfaçage d'une pièce en plastique avec un métal.

L'apport de métal peut se faire suivant deux voies (sérigraphie, évaporation/condensation). La sérigraphie est un procédé en six étapes qui produit une métallisation à faible résolution spatiale (supérieure à 100 micromètres). Etant réalisée sous vide, l'évaporation/condensation se prête très mal à des applications en grande série. Pour ces méthodes, l'adhérence du film métallique (épaisseur inférieure à 1 micromètre par évaporation, ou pouvant atteindre 200 micromètres par sérigraphie) ainsi déposé sur le substrat plastique est insuffisante (inférieure à 0,1 MPa) en regard de la majorité des applications.

Pour accroître de façon significative cette adhérence, il est possible d'agir, avant métallisation, sur la texture ou sur la composition chimique de la surface du plastique. Modifier la texture peut être obtenu par un moyen mécanique augmentant la rugosité (et, par suite, la surface effective de contact). C'est la technique habituelle dont les produits restent très imparfaits (manque d'homogénéité, reproductibilité incertaine, pas de confinement du métal possible). Modifier la texture superficielle peut aussi résulter d'un apport en matières non organiques dans le plastique (fibre de verre, par exemple), sans garantie que l'adhérence du métal sur cet apport serait meilleure que sur le plastique.

La texture superficielle du plastique peut aussi être modifiée par voie chimique. C'est par exemple la technique qui utilise une substance organométallique et qui se décompose en les étapes suivantes :
- la substance est dissoute dans un solvant spécifique;
- la solution est appliquée sur la surface plastique vierge;
- après évaporation du solvant, la substance est conduite à se décomposer sous l'action d'une source d'énergie extérieure (faisceau laser, par exemple) et cette décomposition libère des atomes métalliques sur la surface du plastique;
- la pièce ainsi traitée est plongée dans un bain autocatalytique contenant des ions métalliques. Ceux-ci sont alors conduits à se déposer sur la surface possédant les atomes métalliques libérés précédemment, induisant ainsi sa métallisation.

Un autre procédé du même type consiste à déposer sur la surface d'un plastique, rendue préalablement rugueuse mécaniquement ou par attaque chimique, une substance colloïdale contenant des ions de palladium. Plongée dans une solution autocatalytique, la surface ainsi décorée d'ions de palladium se recouvre alors d'une couche métallique.

Enfin, on peut citer une série de procédés qui consistent à irradier avec un rayonnement laser la surface d'un plastique afin d'éviter au contraire sa métallisation lors de son immersion dans une solution autocatalytique. Ces procédés, dits "négatifs" par contraste aux autres dits "positifs", peuvent avoir un intérêt si la surface à métalliser sur la pièce en plastique a une étendue très supérieure à celle qui ne doit pas être métallisée. Ils opèrent évidemment sur des surfaces qui se métallisent naturellement par voie autocatalytique directe sans traitement particulier.

Les films métalliques produits sur plastique par toutes les techniques "positives" n'ont toutefois pas une adhérence suffisante pour des applications actives en électronique par exemple. En général, ces techniques sont d'autrepart lourdes à mettre en oeuvre du fait de leur grand nombre d'étapes. Elles sont toutes difficiles à utiliser sur de petites surfaces à cause de leur résolution médiocre. Il y a donc nécessité d'améliorer encore les techniques existantes pour former une couche métallique très adhérente et à haute définition sur toute surface plastique.

L'objet principal de la présente invention est d'apporter une solution nouvelle, très simple et élégante, efficace à la formation d'une couche métallique épaisse, très adhérente et à haute définition géométrique sur des plastiques de composition particulière.

On résout ce problème par un procédé de métallisation présentant les particularités de la revendication 1 et des revendications secondaires.

Le procédé de métallisation positive qui fait l'objet de cette invention consiste d'abord à incorporer dans la masse de la matière plastique formée principalement d'un quelconque polymère connu de l'art (par exemple, un polyamide), et au cours de sa mise en forme, une substance inorganique dispersée dans la matière plastique et formée de grains d'oxyde (par exemple : oxydes d'antimoine, d'aluminium, de fer, de zinc ou d'étain), notamment en concentration volumique supérieure à 1 % et de taille variable, mais de préférence n'excédant pas 50 micromètres.

Dans la première étape du procédé décrit dans cette invention, la surface de la matière plastique ainsi constituée (ou composite) est irradiée par un faisceau de lumière émise par un laser. Avantageusement il s'agit d'une lumière ultraviolette, de préférence pendant une durée d'émission très brève (ou pulsation), répétée éventuellement à intervalles de temps régulièrement espacés. Cette émission pulsée est de préférence de forte énergie (par exemple comprise entre 0,05 et 0,2 J), c'est-à-dire qu'elle contient un nombre très élevé de photons. Elle peut aussi opérer à une longueur d'onde inférieure ou égale à 350 nanomètres, correspondant approximativement à une énergie photonique supérieure à 3,5 eV. C'est par exemple le cas avec un laser excimère travaillant pendant 20 nanosecondes, à la longueur d'onde de 248 nanomètres correspondant à une énergie photonique de 5 eV.

Au-dessus d'une densité d'énergie particulière (ou densité d'énergie de seuil) atteinte en focalisant le faisceau sur la surface irradiée (typiquement, 0,5 J/cm²) et dont la valeur dépend de la nature et de la concentration des grains d'oxydes dans le matériau composite, l'action de ce rayonnement est alors double :
a. d'une part, la matière plastique proprement dite (le polymère) subit une ablation superficielle en perdant quelque 0,2 micromètre d'épaisseur par pulsation;
b. d'autre part, et suivant le choix de la substance granulaire incorporée, le même rayonnement crée à la surface des grains qui affleurent en plus grand nombre à la surface du composite (cf. a.) une concentration élevée de défauts obtenus en cassant certaines liaisons interatomiques sous les effets combinés des excitations électroniques résultant de l'absorption des photons par la matière. La concentration de ces défauts à la surface des grains d'oxyde est proportionnelle à la densité d'énergie du laser telle qu'obtenue par focalisation sur la surface du composite.

Dans la deuxième étape du procédé, et sans autre traitement intermédiaire, le composite qui vient d'être traité par le laser est directement immergé dans un bain autocatalytique contenant des ions métalliques (Cu⁺ ou Ni⁺, par exemple) et dont la composition chimique est connue de l'art. Le métal contenu dans le bain se dépose alors sélectivement sur les parties préalablement irradiées par le faisceau laser et contenant les défauts polarisés créés par l'irradiation. La présence de ces défauts sur les grains d'oxydes rend inutile l'étape habituellement pratiquée et inhérente à tout dépôt métallique par voie autocatalytique, à savoir l'immersion du matériau à métalliser dans une solution contenant des ions de palladium préalablement à son immersion dans la solution autocatalytique proprement dite. La méthode de métallisation par voie autocatalytique pratiquée dans le procédé décrit dans cette invention n'utilise aucune substance contenant du palladium en vue d'induire la métallisation au cuivre ou au nickel. Cette métallisation est ici directement induite par la présence des défauts superficiels sur les grains d'oxyde affleurants à la surface du composite.

Au-delà d'un temps d'incubation dont la durée diminue si on augmente la densité d'énergie laser utilisée dans la première étape, l'épaisseur de métal déposé (cuivre ou nickel) est alors sensiblement proportionnelle à la durée de l'immersion réduite du temps d'incubation, soit typiquement 20 ou 5 micromètres par heure au-delà du temps d'incubation, dans un bain de nickel ou de cuivre, respectivement.

L'interface entre composite et métal telle qu'elle est obtenue par le procédé décrit dans cette invention est de facto rugueuse, du fait de l'ablation partielle du polymère. D'autre part, la fixation interstitielle (c'est-à-dire par liaison forte : covalente ou ionique) des ions métalliques du bain autocatalytique sur les défauts des grains inorganiques présents sur cette surface rugueuse est sélective et forte. Ces deux particularités entraînent que l'adhérence du dépôt métallique sur le composite, telle qu'elle est obtenue suivant le procédé décrit dans la présente invention, est la conséquence directe de l'ancrage de la couche métallique sur la surface du composite par l'intermédiaire des grains d'oxydes présents à sa surface et superficiellement métallisé. L'adhérence résultante, qui est de 10 MPa après métallisation, est alors accrue en faisant diffuser le métal vers l'intérieur du composite en utilisant le chauffage sélectif et de courte durée de la couche métallique procuré par un four à micro-ondes. Le polymère et les autres composants non-métalliques de l'ensemble composite/film métallique n'étant pas affecté par les ondes émises par le four, seul le film métallique est alors chauffé et le métal peut alors diffuser dans le composite qui, n'étant pas chauffé dans le même temps, ne fond pas.

Un autre avantage du procédé décrit dans l'invention résulte du fait que la définition des zones métallisées dépend uniquement des conditions de l'irradiation par le laser. En effet, les modifications introduites à la surface du composite par le faisceau de lumière ultraviolette sont limitées aux seules zones irradiées d'une part, et la précision des limites de ces zones est proportionnée à la longueur d'onde utilisée qui est choisie pour être notamment inférieure à 350 nanomètres.

Un dernier avantage du procédé réside dans le fait que, pour chaque formulation du composite, la sensibilisation de la surface au rayonnement du faisceau laser dépend de la densité d'énergie laser incidente. Lors de l'immersion de la surface traitée par le laser dans le bain autocatalytique, la métallisation est d'abord limitée à la surface propre des grains d'oxyde qui émerge du composite. Puis la métallisation se développe de façon hétérogène à partir de ces sites pour couvrir progressivement toute la surface du composite traité par le laser. Le temps d'incubation mesure le temps nécessaire pour atteindre et former une couche métallique continue sur la surface du composite. Au-delà de ce temps, le dépôt métallique peut se développer perpendiculairement à la surface de façon plus efficace (typiquement à 20 micromètres par heure pour le nickel). L'épaisseur de la couche métallique s'accroît alors de façon homogène sur toute la surface, indépendamment de la formulation du composite et du traitement opéré par le laser. Pour un composite donné, on peut aisément irradier sa surface avec un faisceau laser dont la densité d'énergie est variée à volonté. Les portions de surface irradiées à forte densité ont un temps d'incubation au moment du dépôt autocatalytique qui peut être de l'ordre de 10 minutes, alors que d'autres portions de surface, celles-là irradiées à faible densité, ont un temps d'incubation de 50 minutes, par exemple. Le procédé décrit dans cette invention permet donc de produire sur la même surface composite, et pendant une seule immersion dans un bain autocatalytique, des couches métalliques d'épaisseurs différentes.

Tous les avantages du procédé décrit dans cette invention résultent directement de l'utilisation d'un faisceau intense et pulsé de lumière ultraviolette, tel qu'émis par un laser excimère à une longueur d'onde égale ou inférieure à 308 nanomètres. Toute autre source de lumière travaillant dans le visible ou dans l'infrarouge, en régime pulsé ou continu, ne peut produire de défauts de structure et de composition sur les grains d'oxyde incorporés à la base polymère, défauts qui sont nécessaires dans le procédé décrit dans cette invention pour réaliser la métallisation des plastiques de composition spécifique décrits dans l'invention.

Indépendamment de tous les avantages de l'invention qui viennent d'être décrits et qui seront évidents à la présentation des exemples suivants, la liste des adjuvants utiles dans la fonction de métallisation n'est pas limitative.

### Exemple 1

Une plaque de matériau composite contenant respectivement i) 92 % de polyamide-6 (PA-6), et ii) 8 % de Sb₂O₃, de couleur blanche, est irradiée avec une seule pulsation de lumière émise par un laser excimère travaillant à la longueur d'onde de 248 nanomètres, et délivrant une densité d'énergie de 0,5 J/cm² pendant 20 nanosecondes sur la surface du matériau. Sous l'effet de l'absorption du rayonnement du laser, la surface irradiée se colore en brun sombre. La même plaque est ensuite plongée dans une solution autocatalytique maintenue à une température de 38°C, dont le pH est compris entre 8 et 11, et contenant des ions de cuivre en proportion donnée. Suivant cette composition, la surface préalablement irradiée du matériau plastique et ainsi colorée se recouvre progressivement d'une couche de cuivre dont l'épaisseur est de 5 micromètres au bout d'une durée d'immersion d'une heure. L'adhérence est alors évaluée par une méthode standard de tirage ("pull-test") qui donne une force d'arrachement de 10 MPa, soit 1kg/cm².

### Exemple 2

Une pièce en matière plastique, fabriquée en polyamide-6 (PA-6) et contenant un ignifugeant dont la formule comprend Sb₂O₃ dans la proportion volumique de 4 % par rapport au volume total de la pièce, est irradiée avec trois pulsations du faisceau laser utilisé dans l'Exemple 1. La pièce est ensuite plongée dans le même bain autocatalytique que précédemment pendant une heure au bout de laquelle l'épaisseur de métal déposé sur la zone irradiée est égale à 4 micromètres.

### Exemple 3

Une pièce en matière plastique identique à celle décrite dans l'Exemple 2 est déplacée à vitesse constante (3 cm/sec) dans un plan perpendiculaire à l'axe d'un faisceau laser excimère émettant à une fréquence de répétition des pulsations de 10 Hz et dont la section est homogénéisée sur une surface de 3 x 3 mm. L'irradiation et le déplacement de la pièce sont interrompus au bout de 5 secondes. La pièce est ensuite plongée dans le même bain que précédemment pendant 30 minutes. Une épaisseur de métal de 2 micromètres est ainsi obtenue sur une piste de 3 mm de largeur et 15 cm de longueur.

### Exemple 4

Une pièce en matière plastique contenant 92 % de PA-6 et 12 % de poudre de Sb₂O₃ est irradiée par un faisceau laser pulsé travaillant à 248 nanomètres et focalisé sur une surface circulaire de diamètre 0,4 mm sur laquelle une densité d'énergie égale à 0,5 J/cm² est ainsi obtenue. La pièce est montée sur un support que l'on peut déplacer dans un plan perpendiculaire à l'axe du faisceau laser, suivant deux directions orthogonales grâce au pilotage informatisé des déplacements du support dans ces deux directions. La pièce est alors déplacée dans ce plan de telle façon que l'impact du faisceau sur la surface de la pièce décrive un parcours circulaire de diamètre égal à 2 cm. La pièce est ensuite plongée dans le même bain que celui décrit dans les exemples précédents pendant une période d'une heure au bout de laquelle une piste de cuivre circulaire de 2 cm de diamètre est obtenue sur la surface de la pièce, la piste ayant une épaisseur de 5 micromètres et une largeur de 0,4 mm.

### Exemple 5

Une pièce en matière plastique identique à celle de l'Exemple 1 est irradiée sur une surface de 5 x 5 mm par un faisceau laser excimère travaillant à 248 nanomètres et 0,5 J/cm² pendant 20 nanosecondes. Une autre surface de 5 x 5 cm de la même pièce est ensuite irradiée par un faisceau émis par le même laser excimère avec une densité de 0,2 mJ/cm². La pièce est ensuite immergée pendant une heure dans une solution autocatalytique de nickel maintenue à 90°C. Un dépôt métallique se développe sur les deux surfaces irradiées. Les épaisseurs de nickel déposé sur les deux surfaces sont ensuite mesurées être égales à 16 et 3 micromètres sur les surfaces irradiées à 0,5 et 0,2 mJ/cm², respectivement.

### Exemple 6

La pièce utilisée dans l'Exemple 1 est de nouveau métallisée comme dans l'Exemple 1. Elle est ensuite introduite dans un four à micro-ondes de 1.500 watts de puissance pendant 25 secondes. L'adhérence du film de cuivre (épaisseur égale à 5 micromètres) est alors évaluée par la méthode de tirage qui donne une force d'arrachement de 35 MPa.

Il doit être entendu que l'invention n'est nullement limitée aux formes de réalisation décrites et que bien des modifications peuvent être apportées à ces dernières sans sortir du cadre de la présente invention.

On peut par exemple aussi prévoir un bain d'immersion polarisé, à la place du bain autocatalytique, non polarisé.

## Revendications

1. Procédé de métallisation de type positif d'une pièce de matériau plastique composite contenant un polymère et des grains d'un ou plusieurs oxydes, caractérisé en ce qu'il comprend trois étapes successives dont la première consiste en l'irradiation de la surface à métalliser de la pièce par un faisceau de lumière émis par un laser excimère, la seconde consiste en l'immersion de la pièce irradiée dans au moins un bain autocatalytique contenant des ions métalliques et sans apport préalable de palladium, avec dépôt de ceux-ci en une couche sur la surface irradiée et la troisième consiste en un traitement thermique de la pièce plastique métallisée, de façon à obtenir une diffusion du métal déposé dans le matériau plastique.

2. Procédé suivant la revendication 1, caractérisé en ce qu'on utilise, comme source laser, un laser excimère travaillant à une longueur d'onde comprise entre 170 et 360 nanomètres et dont la densité d'énergie est choisie pour produire une concentration élevée de défauts structurels en surface des grains d'oxyde présents à ladite surface du matériau plastique composite, ces défauts permettant la métallisation de ce matériau par immersion dans le bain électrolytique.

3. Procédé suivant l'une des revendications 1 et 2, caractérisé en ce que la lumière émise par le laser traverse un système optique capable d'homogénéiser l'intensité de cette lumière sur toute la section du faisceau de lumière.

4. Procédé suivant la revendication 3, caractérisé en ce que le faisceau de lumière homogénéisée traverse un masque dont la géométrie est plane, et décrit des surfaces carrées, rectangulaires ou circulaires, distribuées dans un plan perpendiculaire à l'axe du faisceau de lumière, notamment sur des dimensions supérieures ou égales à 5 micromètres.

5. Procédé suivant la revendication 4, caractérisé en ce que la pièce à métalliser est maintenue au contact ou à une distance n'excédant pas 0,5 mm de la face arrière du masque au moment de son irradiation.

6. Procédé suivant l'une ou l'autre des revendications 1 et 2, caractérisé en ce que la lumière émise par le faisceau laser est focalisée sur un diamètre égal ou supérieur à 10 micromètres, au moyen d'un système optique sur la surface de la pièce à métalliser.

7. Procédé suivant l'une quelconque des revendications 1 à 6, caractérisé en ce que les grains d'oxyde sont formés de Sb₂O₃, de SnO₂, de Al₂O₃, de ZnO, d'oxydes de fer ou de mélanges d'au moins deux de ces oxydes.

8. Procédé suivant l'une quelconque des revendications 1 à 7, caractérisé en ce que la taille des grains d'oxydes est comprise entre 0,5 et 50 micromètres.

9. Procédé suivant l'une quelconque des revendications 1 à 8, caractérisé en ce que la proportion volumique ou massique de l'oxyde ou des oxydes contenus dans le matériau plastique composite est comprise entre 0,2 et 30 % par rapport au volume total ou à la masse totale de ce matériau.

10. Procédé suivant l'une quelconque des revendications 1 à 9, caractérisé en ce que la pièce métallisée est placée dans un four à micro-ondes permettant de chauffer sélectivement et uniquement la couche métallique pour permettre aux atomes métalliques de diffuser vers l'intérieur de la pièce.

11. Procédé suivant l'une quelconque des revendications 1 à 10, caractérisé en ce que deux ou plusieurs couches métalliques contenant des atomes métalliques différents sont déposées sur une ou plusieurs surfaces de la pièce en plastique, éventuellement pour se recouvrir totalement ou partiellement.

12. Procédé suivant l'une quelconque des revendications 1 à 11, caractérisé en ce que les pièces irradiées par voie automatisée sont portées par un banc mobile se déplaçant continuement en regard du faisceau de lumière.

13. Procédé suivant la revendication 12, caractérisé en ce que les pièces irradiées portées par le banc mobile sont directement conduites par ce même banc mobile pour être immergées dans le bain autocatalytique.

14. Procédé suivant l'une quelconque des revendications 1 à 13, caractérisé en ce que l'épaisseur de la couche métallique obtenue sur les pièces irradiées puis immergées dans le bain autocatalytique et traitées thermiquement dans le four à micro-ondes est déterminée par la densité d'énergie du faisceau laser sur la surface de la pièce irradiée et par la durée de l'immersion dans le bain.

15. Procédé suivant l'une des revendications 1 à 14, caractérisé en ce que chaque pièce métallisée lors d'une première immersion dans un bain autocatalytique contenant un métal est plongée à nouveau dans un autre bain autocatalytique contenant un autre métal, à la suite de quoi la pièce est métallisée par deux couches métalliques différentes superposées.

16. Procédé suivant l'une quelconque des revendications 1 à 15, caractérisé en ce que la pièce à métalliser est successivement irradiée une première fois suivant une géométrie particulière et avec une densité d'énergie particulière, puis immergée dans un premier bain autocatalytique pour être une première fois métallisée, irradiée une deuxième fois suivant une géométrie différente de la première et une densité d'énergie différente de la première, puis immergée une deuxième fois dans un bain autocatalytique différent ou non du précédent, à la suite de quoi la pièce est introduite dans un four à micro-ondes pour permettre aux différents dépôts métalliques de diffuser dans la pièce, la pièce résultante étant métallisée avec deux couches métalliques de géométries et épaisseurs différentes, constituées de métaux identiques ou non.

## Patentansprüche

1. Verfahren zur Positiv-Metallisierung eines Verbundkunststoffteils, das ein Polymer und Körner eines oder mehrerer Oxide enthält, dadurch gekennzeichnet, daß es drei aufeinanderfolgende Schritte umfaßt, in deren erstem die zu metallisierende Fläche des Kunststoffteils mit dem Lichtstrahl eines Excimer-Lasers bestrahlt wird, daß im zweiten Schritt das bestrahlte Teil ohne vorheriges Aufbringen von Palladium in mindestens ein autokatalytisches Bad eingetaucht wird, welches Metallionen enthält, die sich als Schicht auf der bestrahlten Fläche niederschlagen, und das im dritten Schritt eine Wärmebehandlung des metallisierten Kunststoffteils in der Weise erfolgt, daß ein Eindiffundieren des niedergeschlagenen Metalls in den Kunststoff erreicht wird.

2. Verfahren nach Anspruch 1, dadurch gekennzeichnet, daß man als Laserquelle einen Excimer-Laser mit einer Wellenlänge zwischen 170 und 360 nm verwendet, dessen Energiedichte in der Weise gewählt ist, daß eine erhöhte Konzentration von Strukturfehlern in der Oberfläche der Oxidkörner entsteht, die sich in der Oberfläche des Verbundkunststoffs befindet, wobei diese Fehler die Metallisierung dieses Stoffs durch Eintauchen in das Elektrolytbad ermöglichen.

3. Verfahren nach Anspruch 1 oder 2, dadurch gekennzeichnet, daß das von dem Laser abgestrahlte Licht eine Optik durchläuft, die in der Lage ist, die Stärke dieses Lichts im gesamten Querschnitt des Lichtstrahls zu vergleichmäßigen.

4. Verfahren nach Anspruch 3, dadurch gekennzeichnet, daß der vergleichmäßigte Lichtstrahl eine Maske mit einer ebenen Geometrie mit quadratischen, rechteckigen oder kreisförmigen Flächen durchläuft, die in einer Ebene senkrecht zur Achse dcs Lichtstrahls verteilt sind, insbesondere mit Abmessungen von 5 Mikrometern oder mehr.

5. Verfahren nach Anspruch 4, dadurch gekennzeichnet, daß das zu metallisierende Teil während seiner Bestrahlung mit der Rückseite der Maske in Berührung oder zu dieser in einem Abstand von nicht mehr als 0,5 mm gehalten wird.

6. Verfahren nach einem der Ansprüche 1 und 2, dadurch gekennzeichnet, daß das Laserstrahllicht mit Hilfe einer Optik auf der Oberfläche des zu metallisierenden Teils auf einem Durchmesser von 10 Mikrometer oder mehr fokusiert wird.

7. Verfahren nach einem der Ansprüche 1 bis 6, dadurch gekennzeichnet, daß die Oxidkörner gebildet werden aus Sb₂O₃, SnO₂, Al₂O₃, ZnO, Eisenoxiden oder Gemische aus mindestens zwei dieser Oxide.

8. Verfahren nach einem der Ansprüche 1 bis 7, dadurch gekennzeichnet, daß die Größe der Oxidkörner zwischen 0,5 und 50 Mikrometern liegt.

9. Verfahren nach einem der Ansprüche 1 bis 8, dadurch gekennzeichnet, daß der Volumen- oder Massenanteil des Oxids oder der Oxide in dem Verbundkunststoff zwischen 0,2 und 30 % in Bezug auf das Gesamtvolumen oder die Gesamtmasse dieses Stoffs beträgt.

10. Verfahren nach einem der Ansprüche 1 bis 9, dadurch gekennzeichnet, daß das metallisierte Teil in einen Mikrowellenofen eingebracht wird, der ein selektives und gezieltes Erhitzen der Melallschicht ermöglicht, damit die Metallatome in das Innere des Teils hineindiffundieren können.

11. Verfahren nach einem der Ansprüche 1 bis 10, dadurch gekennzeichnet, daß zwei oder mehr Metallschichten mit verschiedenen Metallatomen auf einer oder mehreren Flächen des Kunststoffteils niedergeschlagen werden, gegebenenfalls mit gegenseitiger vollständiger oder teilweiser Überlappung.

12. Verfahren nach einem der Ansprüche 1 bis 11, dadurch gekennzeichnet, daß die auf automatischem Wege bestrahlten Teile von einem beweglichen Tisch getragen werden, der gegenüber dem Lichtstrahl kontinuierlich verschoben wird.

13. Verfahren nach Anspruch 12, dadurch gekennzeichnet, daß die von dem beweglichen Tisch getragenen bestrahlten Teile von demselben beweglichen Tisch direkt weitergeleitet werden, um in das autokatalytische Bad eingetaucht zu werden.

14. Verfahren nach einem der Ansprüche 1 bis 13, dadurch gekennzeichnet, daß die Dicke der auf den bestrahlten und dann in das autokatalytische Bad eingetauchten und in dem Mikrowellenofen thermisch behandelten Teile erhaltene Metallschicht bestimmt wird durch die Energiedichte des Laserstrahls, der auf die bestrahlte Fläche des Teils trifft, außerdem durch die Dauer des Eintauchens in das Bad.

15. Verfahren nach einem der Ansprüche 1 bis 14, dadurch gekennzeichnet, daß jedes metallisierte Teil nach dem ersten Eintauchen in ein ein Metall enthaltendes autokatalytisches Bad von neuem in ein ein anderes Metall enthaltendes autokatalytisches Bad eingetaucht wird, woraufhin das Teil mit zwei unterschiedlichen, übereinanderliegenden Metallschichten metallisiert ist.

16. Verfahren nach einem der Ansprüche 1 bis 15, dadurch gekennzeichnet, daß das zu metallisierende Teil sukzessiv ein erstes Mal entsprechend einer speziellen Geometrie und mit einer speziellen Energiedichte bestrahlt wird, dann in ein erstes autokatalytisches Bad eingetaucht ist, um ein erstes Mal metallisiert zu werden, dann ein zweites Mal entsprechend einer von dcr ersten Geometrie verschiedenen Geometrie und mit einer von der ersten Energiedichte verschiedenen Energiedichten bestrahlt wird, dann ein zweites Mal in ein autokatalytisches Bad eingetaucht wird, welches von dem vorhergehenden Bad verschieden sein kann, woraufhin das Teil in einen Mikrowellenofen eingebracht wird, damit die verschiedenen metallischen Ablagerungen in das Teil eindiffundieren können, wonach das erhaltene Teil mit zwei metallischen Schichten unterschiedlicher Geometrien und Dicken beschichtet ist, welche aus identischen oder nicht-identischen Metallen bestehen.

## Claims

1. Process for the positive-type metallization of a component made of a composite plastic material containing a polymer and particles of one or more oxides, characterized in that it comprises three successive steps, the first of which consists of the irradiation of the surface to be metallized of the component with a light beam emitted by an excimer laser, the second of which consists of the immersion of the irradiated component in at least one autocatalytic bath containing metal ions and without prior addition of palladium, with deposition of these metal ions as a layer on the irradiated surface and the third of which consists of a heat treatment of the metallized plastic component so as to cause diffusion of the deposited metal into the plastic material.

2. Process according to Claim 1, characterized in that, as the laser source, an excimer laser working at a wavelength of between 170 and 360 nanometres is used, the energy density of which is chosen in order to produce a high concentration of structural defects over the surface of the oxide particles present at the said surface of the composite plastic material, these defects allowing metallization of this material by immersion in the electrolysis bath.

3. Process according to one of Claims 1 and 2, characterized in that the light emitted by the laser passes through an optical system capable of making the intensity of this light uniform over the entire cross-section of the light beam.

4. Process according to Claim 3, characterized in that the light beam, rendered uniform, passes through a mask, the geometry of which is plane, and describes square, rectangular or circular areas, these being distributed in a plane perpendicular to the axis of the light beam, especially with dimensions greater than or equal to 5 micrometers.

5. process according to Claim 4, characterized in that the component to be metallized, while it is being irradiated, is held in contact with or at a distance not exceeding 0.5 mm from the rear face of the mask.

6. Process according to either of Claims 1 and 2, characterized in that the light emitted by the laser beam is focused to a diameter equal to or greater than 10 micrometers, by means of an optical system, onto the surface of the component to be metallized.

7. Process according to any one of Claims 1 to 6, characterized in that the oxide particles are formed by Sb₂O₃, from SnO₂, from Al₂O₃, from ZnO, from iron oxides or from mixtures of at least two of these oxides.

8. Process according to any one of Claims 1 to 7, characterized in that the size of the oxide particles is between 0.5 and 50 micrometers.

9. Process according to any one of Claims 1 to 8, characterized in that the proportion by volume or by weight of the oxide or oxides contained in the composite plastic material is between 0.2 and 30 % with respect to the total volume or to the total mass of this material.

10. Process according to any one of Claims 1 to 9, characterized in that the metallized component is placed in a microwave oven enabling just the metal layer to be heated selectively in order to allow the metal atoms to diffuse towards the interior of the component.

11. Process according to any one of Claims 1 to 10, characterized in that two or more metal layers containing different metal atoms are deposited on one or more surfaces of the plastic component, optionally in order to be completely or partially covered.

12. Process according to any one of Claims 1 to 11, characterized in that the automatically irradiated components are conveyed by a moving rig which moves continuously past the light beam.

13. Process according to Claim 12, characterized in that the irradiated components conveyed by the moving rig are conducted directly by this same moving rig in order to be immersed in the autocatalytic bath.

14. Process according to any one of Claims 1 to 13, characterized in that the thickness of the metal layer obtained on the components, which have been irradiated, then immersed in the autocatalytic bath and heat treated in the microwave oven, is determined by the energy density of the light beam over the surface of the irradiated component and by the duration of the immersion in the bath.

15. Process according to any one of Claims 1 to 14, characterized in that each component metallized during a first immersion in an autocatalytic bath containing a metal is dipped once again into another autocatalytic bath containing another metal, after which the component is metallized by two superimposed different metal layers.

16. Process according to any one of Claims 1 to 15, characterized in that the component to be metallized is successively irradiated a first time according to a particular geometry and with a particular energy density, then immersed in a first autocatalytic bath in order to be metallized a first time, irradiated a second time according to a different geometry from the first and with different energy density from the first and then immersed a second time in an autocatalytic bath which may or may not be different from the previous one, after which the component is put into a microwave oven in order to allow the various metal depositions to diffuse into the component, the resulting component being metallized with two metal layers, of different geometries and thicknesses, consisting of identical or non-identical metals.
